(19) Europäisches Patentamt / European Patent Office / Office européen des brevets

(11) **EP 1 623 242 B1**

(12) **EUROPÄISCHE PATENTSCHRIFT**

(45) Veröffentlichungstag und Bekanntmachung des Hinweises auf die Patenterteilung:
**14.04.2010   Patentblatt 2010/15**

(21) Anmeldenummer: **04739062.0**

(22) Anmeldetag: **09.03.2004**

(51) Int Cl.:
***G01R 31/28*** (2006.01)

(86) Internationale Anmeldenummer:
**PCT/EP2004/002420**

(87) Internationale Veröffentlichungsnummer:
**WO 2004/099802 (18.11.2004 Gazette 2004/47)**

(54) **VERFAHREN ZUM TESTEN VON UNBESTÜCKTEN LEITERPLATTEN**

METHOD FOR TESTING BARE PRINTED CIRCUIT BOARDS

PROCÉDÉ POUR TESTER DES CARTES DES CIRCUITS IMPRIMÉES NON-ÉQUIPÉES

(84) Benannte Vertragsstaaten:
**DE FR GB IT**

(30) Priorität: **09.05.2003   DE 10320925**

(43) Veröffentlichungstag der Anmeldung:
**08.02.2006   Patentblatt 2006/06**

(73) Patentinhaber: **atg Luther & Maelzer GmbH
97877 Wertheim/Reicholzheim (DE)**

(72) Erfinder:
 • **ROMANOV, Victor
   97877 Wertheim (DE)**
 • **YUSCHUK, Oleh
   97877 Wertheim (DE)**

(74) Vertreter: **Ganahl, Bernhard et al
Huber & Schüssler
Patentanwälte
Truderinger Strasse 246
81825 München (DE)**

(56) Entgegenhaltungen:
**US-A- 4 926 345     US-A- 5 086 556
US-A- 5 995 232**

 • **PATENT ABSTRACTS OF JAPAN Bd. 0143, Nr. 58 (P-1087), 2. August 1990 (1990-08-02) & JP 2 130477 A (HITACHI LTD; others: 01), 18. Mai 1990 (1990-05-18)**
 • **PATENT ABSTRACTS OF JAPAN Bd. 1999, Nr. 10, 31. August 1999 (1999-08-31) & JP 11 145582 A (MICRO CRAFT KK), 28. Mai 1999 (1999-05-28)**
 • **PATENT ABSTRACTS OF JAPAN Bd. 1998, Nr. 06, 30. April 1998 (1998-04-30) & JP 10 038980 A (NEC CORP), 13. Februar 1998 (1998-02-13)**

**Beschreibung**

Die Erfindung betrifft ein Verfahren zum Testen von unbestückten Leiterplatten mittels eines Fingertesters, der mehrere Prüffinger aufweist, die zum Kontaktieren von Leiterplattentestpunkten einer zu testenden Leiterplatte automatisch verfahren werden.

Prüfvorrichtungen zum Testen von Leiterplatten können grundsätzlich in zwei Gruppen eingeteilt werden, der Gruppe der Fingertester und der Gruppe der Paralleltester. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequentiell abtasten.

Beim Prüfen von unbestückten Leiterplatten müssen im Vergleich zum Prüfen mit bestückten Leiterplatten, dem In-Circuit-Testing, wesentlich mehr Leiterplattentestpunkte kontaktiert werden, weshalb das wesentliche Kriterium für eine erfolgreiche Vermarktbarkeit eines Fingertesters für unbestückte Leiterplatten der Durchsatz an kontaktierten Leiterplattentestpunkten innerhalb einer vorbestimmten Zeit ist.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Zum Kontaktieren einer Kontaktstelle einer zu prüfenden Leiterplatte ist der Schlitten an der Traverse vertikal verschieblich, so dass der Prüffinger von oben bzw. von unten auf die Kontaktstelle der Leiterplatten gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben.

Aus der JP 02-130477 A geht ein Verfahren zum Testen von Leiterplatten mittels eines Fingertester mit einem Prüffinger hervor, wobei dieser zum Kontaktieren von Leiterplattentestpunkten einer zu testenden Leiterplatte automatisch verfahren wird. Der Prüffinger weist eine Prüfsonde auf, die zwei Kontaktspitzen besitzt. Mittels der beiden Kontaktspitzen und einem Kontaktierungssensor wird der Zeitpunkt festgestellt, wann die Prüfsonde mit einem Leiterplattentestpunkt der zu testenden Leiterplatte in Berührung tritt, so dass an Hand dieses Zeitpunktes und der Position der Prüfspitzen das Niveau der Oberfläche des Leiterplattentestpunktes ermittelt wird.

Aus der US 4,926,345 geht eine Vorrichtung zum Trimmen von Leiterbahnen von Leiterplatten hervor. Hierbei werden die Leiterbahnen mittels eines automatischen verfahrbaren Messers auf die gewünschte Breite zu geschnitten. Vor Ausführung des Schneidvorganges wird jedoch mittels eines Sensors der Verlauf dere Leiterbahn erfasst und zudem ein Höhenprofil der Leiterplatte erstellt, so dass der Schneidvorgang mit der gewünschten Genauigkeit ausgeführt werden kann.

In der US 5,489,855 ist ein Fingertester mit mehreren Prüffingern beschrieben.

Der Erfindung liegt die Aufgabe zu Grunde, ein Verfahren zum Testen von unbestückten Leiterplatten mittels eines Fingertesters derart weiterzubilden, dass der Durchsatz an kontaktierten Leiterplattentestpunkten innerhalb einer vorbestimmten Zeit weiter gesteigert werden kann.

Die Erfindung wird durch ein Verfahren mit den Merkmalen des Anspruchs 1 gelöst. Vorteilhafte Ausgestaltungen der Erfindung sind in den Unteransprüchen angegeben.

Beim erfindungsgemäßen Verfahren zum Testen von unbestückten Leiterplatten mittels eines Fingertesters, der mehrere Prüffinger aufweist, die zum Kontaktieren von Leiterplattentestpunkten einer zu testenden Leiterplatten automatisch verfahren werden, wobei die Prüffinger jeweils eine Prüfsonde aufweisen, die mit einem Kontaktierungssensor versehen ist, wird das Niveau der Oberfläche der zu testenden Leiterplatte ermittelt, wenn eine Prüfspitze der Prüfsonde mit der Oberfläche der zu testenden Leiterplatte in Berührung tritt, sodass anhand dieses Zeitpunktes und der Position der Prüfspitze zu diesem Zeitpunkt dieses Niveau feststeht, und weitere Kontaktierungsvorgänge zum Kontaktieren von Leiterplattentestpunkten nach Maßgabe der ermittelten Niveaus angesteuert werden.

Da die Bewegung der Prüffinger nach einem tatsächlich erfassten Niveau der Oberfläche der Leiterplatte angesteuert wird, können die Prüffinger mit hoher Geschwindigkeit nahe bis an die Oberfläche der Leiterplatte bewegt werden, und werden erst beim Erreichen der Oberfläche der Leiterplatte oder kurz vorher zum Kontaktieren eines Leiterplattentestpunktes abgebremst.

Bei herkömmlichen Verfahren wird auf Grund der unterschiedlichen Niveaus von in der Prüfvorrichtung eingesetzten Leiterplatten die Bewegung der Prüffinger bereits wesentlich früher auf eine geringe Geschwindigkeit abgebremst, damit beim Kontaktieren der Leiterplatte die Leiterplattentestpunkte nicht beschädigt werden. Mit der Erfindung kann mit hoher Geschwindigkeit wesentlich näher bis an die Oberfläche zur Leiterplatte gefahren werden, ohne dass hierbei die Gefahr einer Beschädigung der Oberfläche der Leiterplatte besteht.

Das erfindungsgemäße Verfahren ist somit gegenüber herkömmlichen Verfahren schneller und vermeidet Beschädigungen an der Oberfläche der Leiterplatte.

Nach einem bevorzugten Verfahren werden an mehreren Punkten der Oberfläche der Leiterplatte die Niveaus erfasst und anhand der erfassten Niveaus die Oberfläche der Leiterplatte durch Interpolations-Verfahren simuliert. Hierdurch erhält ‚man ein mathematisches Modell der Oberfläche der Leiterplatte. Anhand dieses Modells kann das Niveau eines beliebigen Punktes an der Leiterplatte berechnet werden. Mit diesen Niveaus werden die einzelnen Kontaktierungsvorgänge zum Kontaktieren weiterer Leiterplattentestpunkte angesteuert.

Zudem kann die simulierte Oberfläche auch zum Ermitteln von Abweichungen der X-Koordinaten und Y-Koordinaten der zu kontaktierenden Leiterplattentestpunkte verwendet werden.

Die Erfindung wird nachfolgend anhand den in den Zeichnungen gezeigten Ausführungsbeispielen näher erläutert. In den Zeichnungen zeigen:

Fig. 1     eine erstes Ausführungsbeispiel einer erfindungsgemäßen Prüfsonde in perspektivischer Ansicht,

Fig. 2     die Prüfsonde aus Fig. 1, wobei die Prüfnadel sowohl in der Ausgangsstellung als auch in ausgelenkten Stellungen gezeigt ist,

Fig. 3     ein zweites Ausführungsbeispiel einer erfindungsgemäßen Prüfsonde in perspektivischer Ansicht,

Fig. 4     die Prüfsonde aus Fig. 3 in einer Ansicht, bei der die einzelnen Elemente transparent dargestellt sind,

Fig. 5     ein drittes Ausführungsbeispiel einer erfindungsgemäßen Prüfsonde in perspektivischer Ansicht,

Fig. 6     die Prüfsonde aus Fig. 5 ohne Gehäuse in perspektivischer Ansicht,

Fig. 7     schematisch eine erfindungsgemäße Prüfsonde in der Seitenansicht mit Abmessungen,

Fig. 8     schematisch einen erfindungsgemäßen Fingertester in perspektivischer Ansicht.

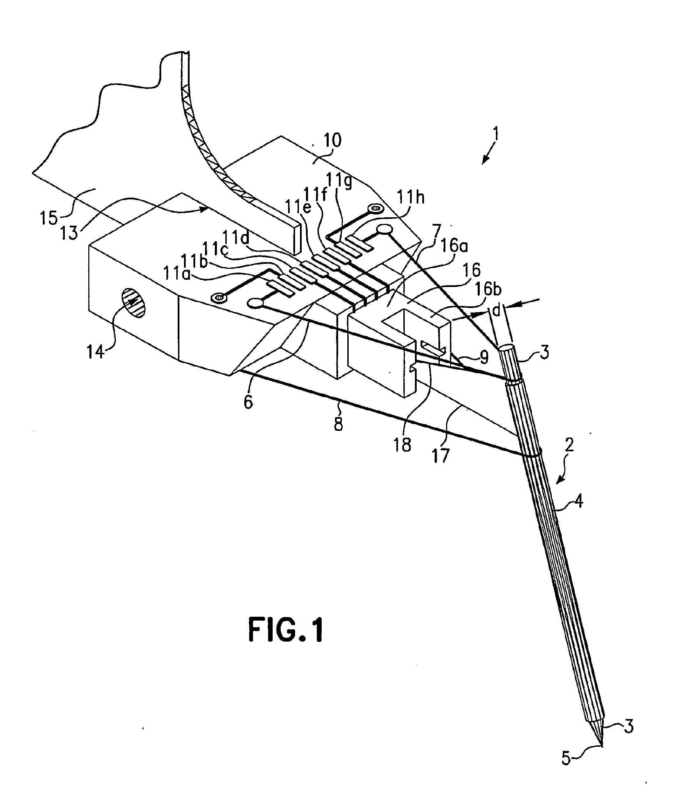

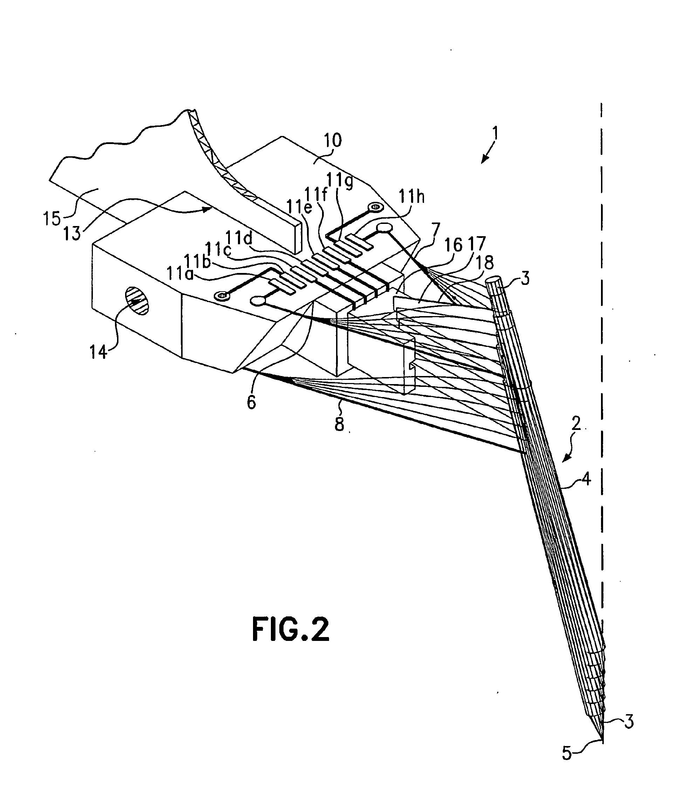

Die Figuren 1 und 2 zeigen ein erstes Ausführungsbeispiel einer erfindungsgemäßen Prüfsonde 1. Die Prüfsonde weist eine Prüfnadel 2 auf, die im vorliegenden Ausführungsbeispiel aus einer Nadel 3 mit einem Durchmesser d von 0,3 bis 0,5 mm ausgebildet ist. Die Nadel 3 besteht z.B. aus Stahl oder Wolfram. Die Nadel 3 ist mit einer Isolationsschicht ummantelt, die z.B. aus Teflon ausgebildet ist. Die Ummantelung ist wiederum mit einer elektrisch leitenden Schicht beschichtet. Diese Ummantelung mit der elektrisch leitenden Schicht bildet eine Abschirmung 4, die die Nadel 3 vor elektrischen Feldern abschirmt. Die Nadel 3 steht mit beiden Enden an der Abschirmung 4 vor, wobei eines der beiden Enden spitz zulaufend zur Ausbildung einer Prüfspitze 5 ausgebildet ist. An dem der Prüfspitze gegenüber liegendem Ende ist die Prüfnadel 2 bzw. die Nadel 3 mit zwei Haltearmen 6, 7 verbunden, die im nachfolgenden als obere Haltearme bezeichnet werden. Zwei weitere Haltearme 8, 9 sind ein Stück beabstandet von der Verbindungsstelle zwischen den oberen Haltearmen 6, 7 und der Prüfnadel 2 an der Abschirmung 4 befestigt. Die Haltearme 8, 9 werden nachfolgend als untere Haltearme bezeichnet. Die beiden Paar Haltearme 6, 7 bzw. 8, 9 sind jeweils aus einem Drahtstück ausgebildet, das in der Mitte abgebogen ist, wobei an der Biegungsstelle die Prüfnadel 2 mittels einer elektrisch leitenden Verbindung, wie z.B. einer Lötverbindung, befestigt ist. Die beiden Paare Haltearme 6, 7 bzw. 8, 9 bilden somit jeweils ein gleichschenkliges Dreieck, wobei sich in der Spitze des gleichschenkligen Dreiecks die Prüfnadel 2 befindet.

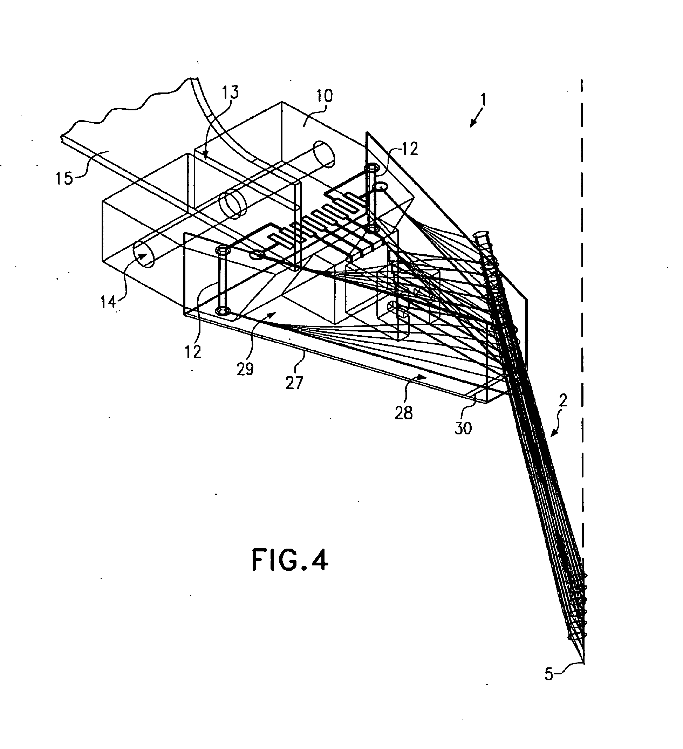

Die Haltearme 6 bis 9 sind mit ihren von der Prüfnadel 2 entfernten Enden an einer Halterung 10 befestigt. Die Halterung 10 ist ein elektrisch isolierendes Kunststoffteil, das an der Oberseite mit einer Reihe von Kontaktflächen 11a bis 11h versehen ist. Die oberen Haltearme 6, 7 sind jeweils über Leiterbahnen mit der Kontaktfläche 11a bzw. 11h elektrisch verbunden. Die unteren Haltearme 8, 9 sind jeweils über einen sich vertikal durch die Halterung 10 erstreckenden elektrisch leitenden Metallstift 12 (Fig. 4) und einer Leiterbahn mit der Kontaktfläche 11b bzw. 11g elektrisch verbunden.

Diese Kontaktflächen 11a bis 11h sind über weitere Leiterbahnen (nicht dargestellt) mit einer an der Halterung 10 ausgebildeten elektrischen Steckverbindung (nicht dargestellt) verbunden. Die Halterung 10 ist als Steckelement ausgebildet, das an einem Prüfkopf eines Fingertesters steckbar ist. Beim vorliegenden Ausführungsbeispiel weist die Halterung 10 eine Schlitz 13 auf, der an der von der Prüfnadel 2 entfernt angeordneten Seitenfläche der Halterung 10 mündet. Zudem weist die Halterung 10 eine Bohrung 14 auf, die quer zum Schlitz 13 angeordnet ist. Die Halterung 10 kann somit mit dem Schlitz auf eine dünne Wandung 15 des Prüfkopfs aufgeschoben und mittels eines die Bohrung 14 der Halterung und eine korrespondierende Bohrung in der Wandung 15 durchsetzenden Stiftes fixiert werden. Beim Aufschieben bzw. -stecken der Halterung 10 auf die Wandung 15 des Prüfkopfes werden gleichzeitig die mit den Kontaktfläche 11a bis 11h verbundenen Leiterbahnen mit korrespondierenden Leiterbahnen des Prüfkopfes elektrisch verbunden.

An der Halterung 10 ist an der zur Prüfnadel 2 benachbart angeordneten Seitenfläche ein Lichtschranken-Element 16 angeordnet. Das Lichtschranken-Element 16 ist in der Draufsicht U-förmig mit einer Basis 16a und zwei Schenkeln 16b ausgebildet. An einem der beiden Schenkel 16b ist innenseitig an seinem Endbereich eine Lichtquelle angeordnet und an dem anderen Schenkel 16b ist ein das Lichtsignal empfangender Lichtsensor angeordnet. Die Lichtquelle und der Lichtsensor bilden somit eine Lichtmessstrecke. Die Lichtquelle und der Lichtsensor weisen in der horizontalen Ebene eine gewisse Längserstreckung auf, die z.B. 1 mm beträgt. An der Prüfnadel 2 ist eine Messfahne 17 befestigt, die z.B. aus einem dünnen Metallblech ausgebildet ist. Diese Messfahne liegt in einer Längsmittenebene der Prüfsonde 1, die vertikal angeordnet ist und die Spiegelebene zu den Haltearmen 6 und 7 bzw. 8 und 9 bildet. Die obere Kante der Messfahne 17 ist als Messkante 18 ausgebildet und verläuft in der in Fig. 1 gezeigten Ausgangsstellung, bei der die Haltearme 6 bis 9 geradlinig verlaufen, schräg bzgl. einer horizontalen Ebene und ist unmittelbar unterhalb der Lichtmessstrecke angeordnet.

Beim Aufsetzen der Prüfsonde 1 auf eine zu testende Leiterplatte wird die Prüfnadel 2 mit einer Kraft beaufschlagt, wodurch die Haltearme aus der Ausgangsstellung in eine ausgelenkte Stellung (nach oben in Fig. 1 und 2) geschwenkt werden. Hierdurch wird die Messfahne 18 in die Lichtmessstrecke eingeführt. Durch das Vorsehen der schrägen Messkante 18 wird die Lichtmessstrecke proportional zum Bewegungsweg der Prüfnadel gegenüber der Halterung 10 unterbrochen, so dass das mit der Lichtschranke gemessene Signal proportional zum Bewegungsweg der Prüfnadel ist.

Das Lichtschranken-Element 16 ist über vier Leiterbahnen jeweils mit einer der Kontaktflächen 11c bis 11f verbunden, die gleichermaßen wie die übrigen Kontaktflächen mittels einer elektrischen Steckverbindung mit dem Prüfkopf verbunden sind.

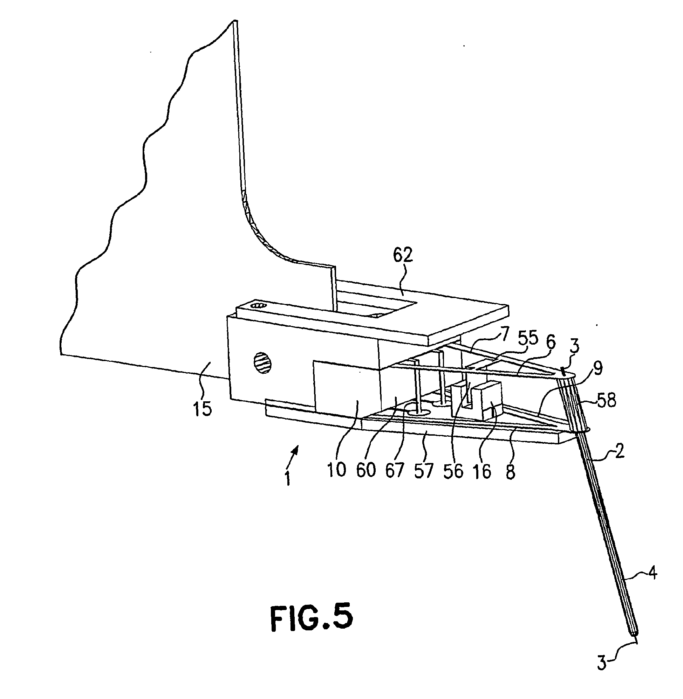

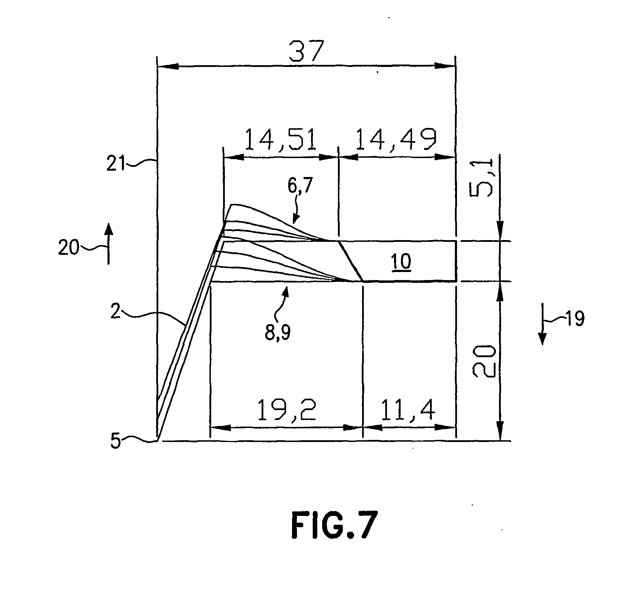

Fig. 7 zeigt schematisch die erfindungsgemäße Prüfsonde 1 in einer Seitenansicht mit der Halterung 10 und den oberen bzw. unteren Haltearmen 6, 7 bzw. 8, 9 und der Prüfnadel 2. Beim in-Berührung-Bringen der Prüfsonde 1 mit einer zu testenden Leiterplatte wird die Prüfsonde 1 mit der Prüfspitze 5 auf die Leiterplatte (Richtung 19) aufgesetzt. Die Prüfnadel 2 wird hierbei bezüglich der Halterung 10 in Richtung des Pfeils 20 (nach oben in Fig. 5) bewegt. Diese Richtung 20 wird nachfolgend als Bewegungsrichtung 20 der Prüfnadel 2 bezeichnet. Die oberen und unteren Haltearme 6, 7 und 8, 9 bilden in der Seitenansicht zusammen mit der entsprechenden Begrenzungskante der Halterung 10 und den zwischen den oberen und unteren Haltearmen angeordneten Abschnitt der Prüfnadel 2 ein Trapez. Die Längen der einzelnen Abschnitte, die in Fig. 7 in Millimeter angegeben sind, sind derart bemessen, dass beim Bewegen der Prüfnadel 2 die Prüfspitze 5 über einen gewissen Weg, von z.B. 5 mm, entlang einer geraden Linie 21 bewegt wird, die senkrecht zu den Ebenen steht, die durch die oberen Haltearme bzw. unteren Haltearme in ihrer Ausgangsstellung aufgespannt werden.

Da die Richtung 19, in welcher die Prüfsonde 1 auf die Leiterplatte zubewegt wird exakt entgegengesetzt zur Bewegungsrichtung 20 der Prüfnadel bzgl. der Halterung 10 ist und die Prüfspitze entlang einer geraden Linie parallel zur Bewegungsrichtung 20 bewegt wird, wird keine Bewegungskomponente parallel zur Oberfläche der zu testenden Leiterplatte erzeugt, wodurch sichergestellt ist, dass die Prüfspitze 5 die Oberfläche der Leiterplatte nicht verkratzt. Die Prüfspitze wird somit beim Aufsetzen der Prüfsonde auf dem Prüfling nicht bewegt.

Vorzugsweise wird die Bewegung der Prüfsonde 1 durch das von der Lichtschranke erfasste Signal gesteuert. Wird die Prüfnadel 2 in Bewegungsrichtung 20 bewegt, so tritt die Messfahne 17 in die Lichtmessstrecke ein, was durch ein entsprechendes elektrisches Signal erfasst wird. Da das Signal proportional zum Weg der Prüfnadel 2 ist, kann anhand des Messsignales festgestellt werden, wie weit die Prüfnadel aus der Ausgangsstellung bewegt worden ist. Ab einem bestimmten Auslenkungsweg, der z.B. 1 mm beträgt, kann die Bewegung der Prüfsonde 1 abgebremst werden.

Hierdurch wird die maximale Auslenkung der Prüfnadel 2 bzgl. der Halterung 10 begrenzt, wodurch die Federkraft, die von den Haltearmen über die Prüfnadel 2 auf die Leiterplatte ausgeübt wird wiederum begrenzt wird. So kann die auf eine Leiterplatte ausgeübte Kraft sehr gering gehalten werden, selbst wenn die Prüfsonde 1 mit hoher Geschwindigkeit auf die zu testende Leiterplatte zugeführt wird, wird aufgrund des geringen übertragenen Bewegungsimpulses und der begrenzten Federkraft die Oberfläche der zu testenden Leiterplatte nicht beschädigt.

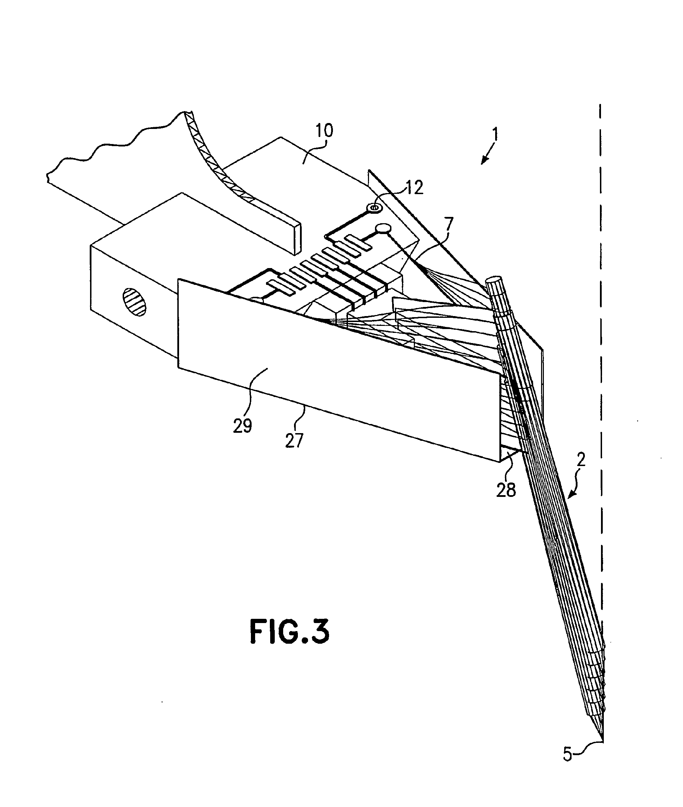

Fig. 3 und 4 zeigen ein zweites Ausführungsbeispiel, bei welchem die Haltearme 6 bis 9 innerhalb einer elektrisch leitenden Wanne 27 angeordnet sind, die die als elektrische Zuleitung fungierenden Haltearme gegenüber elektrischer Strahlung abschirmen. Diese Wanne 27 weist eine Bodenwandung 28 und zwei Seitenwandungen 29 auf.

Die Wanne 27 ist, wie die unteren Haltearme 8, 9 elektrisch mit den Stiften 12 verbunden, die auf Masse liegen. Benachbart zur Prüfnadel 2 ist auf der Bodenwandung 28 ein Quersteg 30 angeordnet, der die Bewegung der unteren Haltearme 8, 9 nach unten begrenzt, wobei der Quersteg 30 höher angeordnet ist, als die Befestigungsstelle der unteren Haltearme 8, 9 an der Halterung 10. Hierdurch ist die Einheit aus Prüfnadel 2 und den Haltearmen 7 bis 9 gegenüber der in Fig. 1 gezeigten Ausgangsstellung ein Stück nach oben angehoben und die Haltearme 6 bis 9 stehen unter einer Vorspannung.

Diese Vorspannung dient dazu, dass bei einer schnellen Beschleunigung der Prüfsonde 1 aufgrund der bei der Beschleunigung auftretenden Kräfte die Prüfnadel 2 nicht gegenüber der Halterung 10 bewegt wird und evtl. mit ihrer Messfahne die Lichtschranke in unerwünschter Weise auslösen würde.

Im Rahmen der Erfindung ist es auch möglich, dass an Stelle einer Wanne ein rohrförmiges Abschirmelement vorgesehen wird, das die Haltearme auch nach oben hin abschirmt.

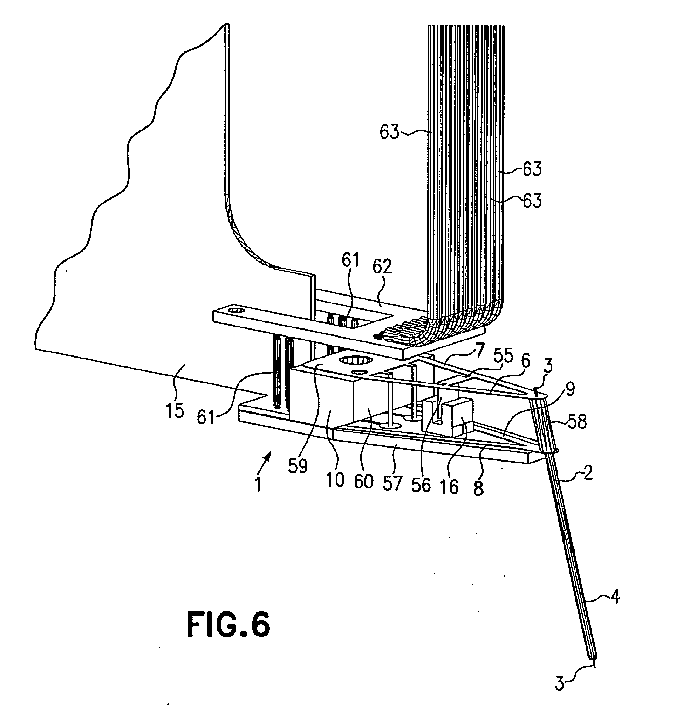

Ein drittes Ausführungsbeispiel der Prüfsonde (Fig. 5, 6) ist ähnlich ausgebildet wie die beiden oben beschriebenen Ausführungsbeispiele, weshalb gleiche Teile mit gleichen Bezugszeichen bezeichnet werden. Die beiden oberen Haltearme 6, 7, und die beiden unteren Haltearme 8, 9 sind jeweils durch Ätzen aus einem dünnen Kupfer/Beryllium-Blech oder Federstahl mit einer Wandstärke von ca. 50 $\mu$m bis 200 $\mu$m hergestellt. Es sind alle Bleche geeignet, die eine gute elektrische Leitfähigkeit und gute elastische Eigenschaften besitzen. Die Haltearmpaare sind deshalb schmale Blechstreifen, die in der Draufsicht V-förmig angeordnet sind. Etwa längsmittig ist zwischen den oberen Haltearmen 6, 7 ein Quersteg 55 ausgebildet, an dem eine Messfahne 56 angebunden und nach unten abgewinkelt ist. Der Quersteg befindet sich an dem Ort der Haltearme, an dem die Krümmungsrichtung der Haltearme bei einer Auslenkung wechselt (= Wendepunkt) (Fig. 7).

Die Messfahne 56 weist wiederum eine Messkante (nicht gezeigt) auf, die in ein Lichtschranken-Element 16 eingreift. Diese Messkante ist jedoch horizontal ausgebildet und die Lichtquelle und der Lichtsensor sind in vertikaler Richtung erstreckend ausgebildet, so dass das Lichtschranken-Element 16 ein zur Eintauchtiefe der Messfahne 56 proportionales Signal ausgibt. Die Haltearme 6, 7 bzw. 8, 9 enden jeweils an einem Plättchen 59, das an der Halterung 10 bspw. mittels einer Klebe-, Schraub- oder Nietverbindung befestigt ist.

Die unteren Haltearme 8, 9 liegen auf einer Basisplatte 57 auf, die aus einem nicht elektrisch leitenden Material ausgebildet ist. Die Basisplatte 57 ist in der Draufsicht im Bereich von der Halterung 10 zur Prüfnadel 2 V-förmig, d.h., von der Halterung 10 zur Prüfnadel 2 spitz zulaufend ausgebildet. Die Basisplatte 57 begrenzt die Bewegung der Haltearme nach unten.

Die Prüfnadel 2 ist wie bei den beiden oben beschriebenen Ausführungsbeispielen mit einer Nadel 3 und einer Abschirmung 4 ausgebildet und angeordnet. Im Bereich zwischen den unteren und oberen Haltearmen 8, 9 und 6, 7 weist sie eine Abstandshülse 58 auf, die aus elektrisch isolierendem Material ausgebildet ist und die Abschirmung 4 im Bereich zwischen den Haltearmen 8, 9 und 6, 7 umschließt. Die Abstandshülse 58 ist mit den Haltearmen 6, 7 und 8, 9 mechanisch verbunden, so dass die Haltearme mit ihren von der Halterung 10 entfernten Ende auf Abstand gehalten werden. Die oberen Haltearme 6, 7 sind elektrisch mit der Nadel 3 und die unteren Haltearme 8, 9 sind elektrisch mit der Abschirmung 4 verbunden.

Die Halterung 10 ist bei diesem Ausführungsbeispiel ein etwa quaderförmiger Körper, der auf der Basisplatte 57 angeordnet ist, wobei sich zwischen der Halterung 10 und der Basisplatte 57 das Plättchen der unteren Haltearme 8, 9 befindet. Die untere Kante der zur Prüfnadel 2 weisenden Wandung 60 der Halterung 10 ist abgeschrägt, so dass die unteren Haltearme 6, 7 ein Stück freigelegt sind und sich ab einem Bereich hinter der Wandung 60 frei nach oben bewegen können.

Die Basisplatte 57 steht an der von der Prüfnadel 2 abgewandten Seite ein Stück von der Halterung 10 vor. In diesem Bereich sind Kontaktstellen auf der Basisplatte 57 angeordnet, von welchen Kontaktsifte 61 nach oben führen und an einer Kontaktplatte 62 enden, an welcher elektrische Leitungen 63 befestigt sind, die mit den Kontaktstiften 61 elektrisch verbunden sind und mit welchen die Prüfsonde 1 elektrisch mit der Prüfvorrichtung verbunden ist. Die Basisplatte 57 ist in diesem Bereich auch mechanisch an die Wandung 15 des Prüfkopfes gekoppelt.

Über Leiterbahnen auf der Basisplatte 57 sind das Lichtschranken-Element 16 und die oberen Haltearme 6, 7 mit den Kontaktstiften 61 elektrisch verbunden, wobei von dem Plättchen 59 der oberen Haltearme Verbindungsstege 67 nach unten auf die Basisplatte 57 führen und an entsprechende Leiterbahnen kontaktiert sind.

In der Funktionsweise entspricht das dritte Ausführungsbeispiel der Prüfsonde den beiden oben beschriebenen Ausführungsbeispielen.

Bei einer weiteren Ausführungsform können an Stelle einer Prüfnadel pro Prüfsonde zwei parallel nebeneinander liegende Prüfnadeln angeordnet und von den Haltearmen getragen werden, so dass eine 4-Draht-Messung ausgeführt werden kann, bei welcher dieser die Stromquelle und der die Spannungsquelle beinhaltende Stromkreis erst am Leiterplattentestpunkt 22 zusammengeführt werden.

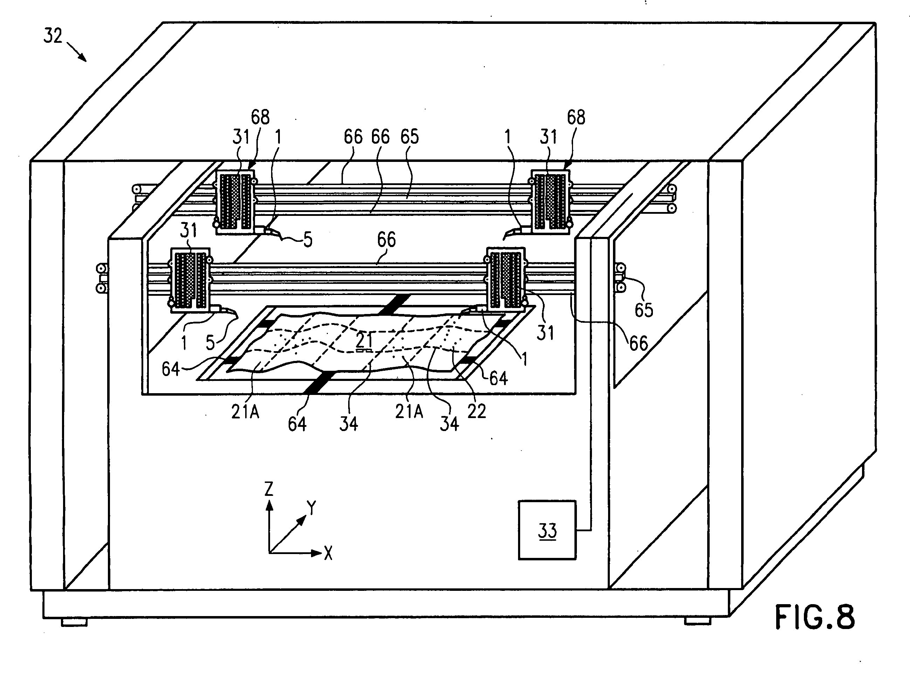

Fig. 8 zeigt schematisch eine Prüfvorrichtung 32 zum Testen von unbestückten Leiterplatten 21, die ein Fingertester 32 ist. Der Fingertester weist mehrere Prüfköpfe 68 auf, die jeweils aus einer erfindungsgemäßen Prüfsonde 1 und einem Linearantrieb 30 ausgebildet sind. Der Linearantrieb 31 ist derart angeordnet, dass er im wesentlichen senkrecht auf der zu testenden Leiterplatte 21 ausgerichtet ist, das heißt, dass die Prüfsonde 1 in einer Richtung im wesentlichen senkrecht zur Leiterplatte 21 durch den Linearantrieb 30 bewegbar ist. Vorzugsweise ist der Linearantrieb 30 ein Linearmotor, wie er beispielsweise in der deutschen Patentanmeldung DE 101 60 119.0-35 beschrieben ist. Als Linearantrieb kann jedoch jede andere geeignete Antriebseinheit verwendet werden.

Der Fingertester 32 besitzt einen Bereich zur Aufnahme der zu testenden Leiterplatte 21, die mittels Halteelementen 64 gehalten wird. Im Bereich oberhalb dieses Aufnahmebereichs ist zumindest eine Traverse 65 angeordnet, die sich über diesen Aufnahmebereich erstreckt. Vorzugsweise sind es mehrere Traversen 65, die feststehend oder auch beweglich am Fingertester ausgebildet sind. Sind die Traversen 65 ortsfest an dem Fingertester angeordnet, so sind die Prüfköpfe mit einer Schwenkeinrichtung versehen, mit welcher zumindest die jeweilige Prüfsonde 1 um eine vertikale Achse geschwenkt werden kann.

Jeder der Prüfköpfe 68 ist jeweils an einen Förderriemen 66 gekoppelt, mit welchen er automatisch entlang der jeweiligen Traverse 65 verfahrbar ist. An einer Traverse sind vorzugsweise zwei Prüfköpfe 68 angeordnet, so dass an den Traversen 65 jeweils zwei Förderriemen 66 angeordnet sind.

Im Betrieb werden die Prüfsonden 1 mit ihren Prüfspitzen 5 durch eine Bewegung in der Ebene parallel zur Leiterplatte 21 über einen zu testenden Leiterplattentestpunkt 21 A positioniert. Danach wird die Kontaktspitze auf den Leitarplattentestpunkt 21 A mittels des Linearantriebs 30 abgesenkt, bis die Prüfspitze 5 den Leiterplattentestpunkt kontaktiert. Hieran schließt sich die elektrische Messung an, nach der die Prüfsonde wieder angehoben und zum nächsten Leiterplattentestpunkt verfahren wird.

Der in Fig. 8 gezeigte Fingertester weist Prüfköpfe nur an einer Seite der zu testenden Leiterplatte 21 auf. Im Rahmen der Erfindung ist es selbstverständlich möglich den Fingertester mit Prüfköpfen, Traversen, etc.

auf beiden Seiten der zu testenden Leiterplatte auszubilden.

Die erfindungsgemäße Prüfvorrichtung 32 weist eine Steuereinrichtung 33 auf, welche in Fig. 8 schematisch durch ein Rechteck dargestellt ist und zum automatischen Steuern der Bewegung der Prüfsonde 1 in allen drei Raumrichtungen ausgebildet ist. Mittels der als Kontaktsensoren dienenden Lichtschranken-Elemente 16 der Sonden 1 stellt die Steuereinrichtung 33 den Zeitpunkt der Kontaktierung der zu testenden Leiterplatte 21 fest. Wird zu diesem Zeitpunkt die Z-Koordinate der Prüfspitze 5 erfasst, so wird die Höhe der zu testenden Leiterplatte 21 an dem entsprechenden Berührungspunkt der zu testenden Leiterplatte 21 festgestellt.

Vom erfindungsgemäßen Verfahren werden auf diese Art und Weise die Höhe der Oberfläche der zu testenden Leiterplatte 21 erfasst. Bei einem weiteren Kontaktiervorgang wird die Prüfsonde nach Maßgabe der vorher erfassten Höhe der Oberfläche der Leiterplatte 21 angesteuert, das heißt, dass die Prüfsonde in Z-Richtung mit der Prüfspitze 5 bis zu der Höhe in Z-Richtung mit hoher Verfahrgeschwindigkeit bewegt wird und erst beim Erreichen dieser Höhe oder kurz davor abgebremst wird. Kurz davor bedeutet, dass beim Erreichen eines Abstandes von weniger als 1 oder 2 Millimeter der Prüfspitze 5 von der erfassten Oberfläche der Leiterplatte, die Prüfsonde abgebremst wird. Die Prüfsonde 1 wird dann mit einer geringeren Geschwindigkeit bewegt, bis mittels der Kontaktierungssensoren 16 eine tatsächliche Berührung der Oberfläche der Leiterplatte 21 festgestellt wird.

Hierdurch wird das Prüfverfahren automatisch an das Niveau der Oberfläche der zu testenden Leiterplatte 21 angepasst, das oftmals etwas variieren kann.

Vorzugsweise wird die Bewegung der Prüfsonden in Z-Richtung derart gesteuert, dass die Prüfsonden beim Kontaktieren der zu testenden Leiterplatte angehalten werden, wenn die Kontaktierungssensoren 16 eine bestimmte Kontaktkraft detektieren, mit welcher die Prüfspitze 5 gegen die Oberfläche der Leiterplatte gedrückt wird. Bei den Kontaktierungssensoren 16 gemäß dem vorliegenden Ausführungsbeispiel entspricht die vorbestimmte Kontaktkraft einer bestimmten, von den Lichtsschranken-Elementen detektierten Lichtmenge. Sollte während des Kontaktes mit einer Leiterplatte eine Änderung der Lichtmenge beziehungsweise in der Kontaktkraft festgestellt werden, werden die Prüfsonden entsprechend in Z-Richtung nachjustiert. Dies ist beim Testen von elastischen Leiterplatten sehr von Vorteil, da es sein kann, dass mehrere Prüffinger eine elastische Leiterplatte gleichzeitig an eng nebeneinander liegenden Leiterplattentestpunkten kontaktieren. Hierdurch kann die elastische Leiterplatte ein Stück durchgedrückt werden, wodurch der Ort der Oberfläche der Leiterplatte verändert wird. Die einzelnen Prüfsonden werden entsprechend nachgefahren, so dass selbst bei einer derart zeitlich veränderlichen Oberflächenform eine sichere Kontaktierung mit vorbestimmter Kontaktkraft gewährleistet ist.

Nach einer bevorzugten Ausführungsform der erfindungsgemäßen Verfahrens wird nicht alleine ein Niveau der Oberfläche der zu testenden Leiterplatte 21 ermittelt, sondern werden die Niveaus mehrerer Punkte auf der Leiterplatte ermittelt und die Oberfläche der zu testenden Leiterplatte 21 mittels einer Interpolation simuliert. Dies ist besonders bei biegsamen Leiterplatten von Vorteil, da solche Leiterplatten durch ihre Biegsamkeit sich wellen können und somit in der Prüfvorrichtung 32 eine dreidimensional geformte Oberfläche bilden. In Fig. 8 sind fiktive Gitterlinien 34 eingezeichnet. Zu Beginn der Prüfvorgangs beim Testen einer einzelnen zu testenden Leiterplatte 21 werden die Niveaus im Bereich der Kreuzungspunkte der Gitterlinien 34 erfasst. Anhand dieser Niveaus wird die gesamte Oberfläche der zu testenden Leiterplatte mittels eines Interpolationsverfahrens simuliert.

Anhand dieser simulierten Oberfläche ermittelt die Steuereinrichtung 33 selbsttätig die Z-Koordinate eines jeden einzelnen zu testenden Leiterplattentestpunktes. Dies bedeutet, dass jeder einzelne zu testende Leiterplattentestpunkt bezüglich seiner Z-Koordinate individuell angesteuert wird, wobei die Prüfsonde mit ihrer Prüfspitze 1 mit hoher Geschwindigkeit bis zum Niveau des einzelnen Leiterplattentestpunktes oder bis kurz davor gefahren wird und dann die Bewegung der Prüfsonde 1 abgebremst wird, bis tatsächlich eine Berührung mittels des Kontaktierungssensors festgestellt wird.

Bei dreidimensional geformten Leiterplatten, insbesondere welligen Leiterplatten, wird hierdurch beim Prüfen der Leiterplatte ein wesentlicher Zeitgewinn erzielt, da die einzelnen zu testenden Leiterplattentestpunkte mit ihren tatsächlich ermittelten Z-Koordinaten angesteuert werden.

Bei stark gewellten Leiterplatten können sich auch auf Grund der Wellung der Leiterplatte Abweichungen der X-Koordinaten und Y-Koordinaten der Leiterplattentestpunkte gegenüber ihren Soll-Koordinaten ergeben. Da die Form der Oberfläche der Leiterplatte simuliert ist, können hieraus auch einfach die entsprechenden Abweichungen ermittelt werden.

Bei herkömmlichen Prüfvorrichtungen, insbesondere, wenn sie keinen Kontaktierungssensor aufweisen, besteht zudem das Problem, dass wellige Leiterplatten oftmals mit einem oberhalb der Leiterplatte angeordneten Sensor nicht korrekt kontaktiert werden, wenn sich die Leiterplatte nach unten durchbiegt, da die Prüfsonde nicht soweit nach unten gefahren wird. Selbst derart von den Prüfsonden 1 weggebogenen Leiterplatten werden mit dem erfindungsgemäßen Verfahren zuverlässig kontaktiert, wobei außerdem alle Leiterplattentestpunkte schnell angefahren werden können.

Als Interpolationsverfahren wird vorzugsweise das Spline-Interpolations-Verfahren verwendet. Hierbei wird durch vorbestimmte Punkte der zu simulierenden Ebene eine Kurve mit Hilfe einer Spline-Funktion

$$s: [x_1, x_n] > R$$

gelegt. Dies ist durch folgende Bedingungen festgelegt:

a) $s (x_i = y_i)$ das heißt, die Ausgangspunkte liegen auf dem Graphen von s;
b) $s = [x_1, x_n]$ zweimal stetig differenzierbar;
c) die Gesamtkrümmung von s ist minimal, das heißt, alle anderen Funktionen, die die beiden ersten Bedingungen erfüllen, besitzen eine größere Gesamtkrümmung.

Es hat sich herausgestellt, dass s in jedem Intervall $[x_i, x_{i+1}]$ höchstens ein Polynom dritten Grades ist. Die Spline-Interpolation ergibt hierdurch sehr glatte Kurven.

Mit dem erfindungsgemäßen Verfahren wird somit auf einfache Art und Weise das Messverfahren an das Niveau einer zu testenden Leiterplatte angepasst.

Die Erfindung kann folgendermaßen kurz zusammengefässt werden:

Die Erfindung betrifft ein Verfahren zum Testen von Leiterplatten, inbesondere von unbestückten Leiterplatten.

Beim erfindungsgemäßen Verfahren wird das Niveau der Oberfläche einer zu testenden Leiterplatten bei einem Kontaktierungsvorgang automatisch erfasst und die weiteren Kontaktierungsvorgänge werden dann nach Maßgabe des erfassten Niveau angesteuert.

Hierdurch erfolgt bei der Ansteuerung der Bewegung der Prüfsonden des Fingertesters eine automatische Anpassung an das Niveau, was insbesondere beim Testen von biegsamen Leiterplatten von Vorteil ist, da deren Oberfläche eine dreidimensionale Form ausbilden kann.

Bezugszeichenliste

| | |
|---|---|
| 1 | Prüfsonde |
| 2 | Prüfnadel |
| 3 | Nadel |
| 4 | Abschirmung |
| 5 | Prüfspitze |
| 6 | Haltearm |
| 7 | Haltearm |
| 8 | Haltearm |
| 9 | Haltearm |
| 10 | Halterung |
| 11 | Kontaktfläche |
| 12 | Stift |
| 13 | Schlitz |
| 14 | Bohrung |
| 15 | Wandung des Prüfkopfs |
| 16 | Lichtschranken-Element |
| 16a | Basis |
| 16b | Schenkel |
| 17 | Messfahne |
| 18 | Messkante |
| 19 | Bewegungsrichtung beim Kontaktieren |
| 20 | Bewegungsrichtung |
| 21 | Leiterplatte |
| 21 A | Leiterbahn |
| 22 | Leiterplattentestpunkt |
| 23 | Leiter |
| 24 | Stromquelle |
| 25 | Leiter |
| 26 | Spannungsmesser |
| 27 | Wanne |
| 28 | Bodenwandung |
| 29 | Seitenwandung |
| 30 | Quersteg |
| 31 | Linearantrieb |
| 32 | Prüfvorrichtung |
| 33 | Steuereinrichtung |
| 34 | Gitterlinien |
| 55 | Quersteg |
| 56 | Messfahne |
| 57 | Basisplatte |
| 58 | Abstandshülse |
| 59 | Plättchen |
| 60 | Wandung |
| 61 | Kontakstift |
| 62 | Kontaktplatte |
| 63 | Leitung |
| 64 | Halteelement |
| 65 | Traverse |
| 66 | Förderriemen |
| 67 | Verbindungssteg |
| 68 | Prüfkopf |

**Patentansprüche**

1. Verfahren zum Testen von unbestückten Leiterplatten mittels eines Fingertesters, der mehrere Prüffinger aufweist, die zum Kontaktieren von Leiterplattentestpunkten einer zu testenden Leiterplatte automatisch verfahren werden, wobei die Prüffinger jeweils eine Prüfsonde (1) aufweisen, die mit einem Kontaktierungssensor (16) versehen ist, mit dem ermittelt wird, wenn eine Prüfspitze (5) der Prüfsonde (1) mit der Oberfläche der zu testenden Leiterplatte in Berührung tritt, **dadurch gekennzeichnet, dass** anhand dieses Zeitpunktes und der Position der Prüfspitze (5) zu diesem Zeitpunkt das Niveau der Oberfläche der zu testenden Leiterplatte (21) ermittelt wird, und Kontaktierungsvorgänge zum Kontaktieren weiterer Leiterplattentestpunkte nach Maßgabe des ermittelten Niveaus angesteuert werden.

2. Verfahren nach Anspruch 1,

**dadurch gekennzeichnet**
**dass** das beim Kontaktieren eines Leiterplattentestpunktes die Prüfsonden (1) mit hoher Geschwindigkeit in Richtung zum Leiterplattentestpunkt (21 A) bewegt werden und beim Erreichen des vorab erfassten Niveaus oder kurz davor auf einer geringere Geschwindigkeit abgebremst werden.

3. Verfahren nach Anspruch 2,
**dadurch gekennzeichnet,**
**dass** die Bewegung der Prüfsonde (1) beim Kontaktieren eines Leiterplattentestpunktes angehalten wird, sobald durch den Kontaktierungssensor (16) eine Berührung mit der Leiterplatte festgestellt wird.

4. Verfahren nach einem der Ansprüche 1 bis 3,
**dadurch gekennzeichnet,**
**dass** mit dem Kontaktierungssensor (16) eine bestimmte Kontaktkraft festgestellt wird, mit welcher die Prüfsonde (1) gegen eine zu testenden Leiterplatte (21) gedrückt wird, und falls eine Abweichung der detektierten Kontaktkraft von einer vorbestimmten Kontaktkraft festgestellt wird, die Prüfsonde (1) entsprechend nachjustiert wird.

5. Verfahren nach einem der Ansprüche 1 bis 4,
**dadurch gekennzeichnet,**
**dass** von mehreren über der Leiterplatte verteilt angeordneten Punkten die Niveaus erfasst werden und anhand der erfassten Niveaus die Oberfläche der Leiterplatte durch ein Interpolations-Verfahren simuliert wird, wobei die simulierte Oberfläche zum Ansteuern weiterer Kontaktierungsvorgänge verwendet wird.

6. Verfahren nach Anspruch 5,
**dadurch gekennzeichnet,**
**dass** das Interpolations-Verfahren das Spline-Interpolations-Verfahren s ist.

7. Verfahren nach einem der Ansprüche 1 bis 6,
**dadurch gekennzeichnet,**
**dass** an Hand der simulierten Oberfläche Veränderungen der X-Koordinaten und Y-Koordinaten von zu testenden Leiterplattentestpunkten gegenüber ihren Soll-Koordinaten berechnet werden und nach Maßgabe dieser geänderten X-Koordinaten und Y-Koordinaten die Leiterplattentestpunkte angesteuert werden.

8. Verfahren nach einem der Ansprüche 1 bis 7,
**dadurch gekennzeichnet,**
**dass** eine biegsame Leiterplatte getestet wird.

9. Verfahren nach einem der Ansprüche 1 bis 8,
**dadurch gekennzeichnet,**
**dass** als Kontaktierungssensor eine Lichtschranke (16) mit einer Lichtmessstrecke verwendet wird, in die eine mit einer Prüfnadel (2) verbundene Fahne (17) zum Unterbrechen der Lichtmessstrecke eingreift.

10. Verfahren nach einem der Ansprüche 1 bis 9,
**dadurch gekennzeichnet,**
**dass** eine Prüfsonde (1) verwendet wird, die eine Prüfnadel (2) aufweist, deren Prüfspitze (5) mit den Leiterplattentestpunkten (22) in Kontakt bringbar ist, und die mittels zwei Paar elastisch federnder Haltearme (6, 7, 8, 9) schwenkbar an einer Halterung (10) befestigt ist, wobei jeweils ein Paar Haltearme in einer Ebene angeordnet sind, mit einem Ende an der Prüfnadel (2) und mit dem anderen Ende an der Halterung (10) befestigt sind und in der Draufsicht jedes Paar Haltearme ein Dreieck aufspannt.

11. Prüfvorrichtung mit einer Steuereinrichtung zur Durchführung des Verfahrens nach einem der Ansprüche 1 bis 10.

**Claims**

1. Method for the testing of non-componented circuit boards using a finger tester with several test fingers which are moved to contact circuit board test points of a circuit board to be tested, wherein each of the test fingers has a test probe (1) provided with a contacting sensor (16) which determines when a probe tip (5) of the test probe (1) makes contact with the surface of the circuit board to be tested, **characterised in that**, with the aid of this point in time and the position of the probe tip (5) at this point in time, the level of the surface of the circuit board (21) to be tested is determined, and contacting processes for the contacting of further circuit board test points on the basis of the determined level are activated.

2. Method according to claim 1,
**characterised in that**
when a circuit board test point is contacted, the test probes (1) are moved at high speed towards the circuit board test points (21A), and are braked to a lower speed on or just before reaching the level determined beforehand.

3. Method according to claim 2,
**characterised in that**
in the contacting of a circuit board test point, the movement of the test probe (1) is stopped as soon as contact with the circuit board is determined by the contacting sensor (16).

4. Method according to any of claims 1 to 3
**characterised in that**
the contacting sensor (16) determines a specific contact force with which the test probe (1) is pressed against a circuit board (21) to be tested and, if a deviation of the detected contact force from a predetermined contact force is found, the test probe (1) is readjusted accordingly.

5. Method according to any of claims 1 to 4 **characterised in that** the levels of several points distributed over the circuit board are determined and, with the aid of the detected levels, the surface of the circuit board is simulated by an interpolation method, with the simulated surface being used to activate further contacting processes.

6. Method according to claim 5 **characterised in that** the interpolation method is the spline interpolation method s.

7. Method according to any of claims 1 to 6 **characterised in that** with the aid of the simulated surface, variations from their specified coordinates of the X coordinates and Y coordinates of circuit board test points to be tested are calculated, and the circuit board test points are selected on the basis of these altered X coordinates and Y coordinates.

8. Method according to any of claims 1 to 7 **characterised in that** a flexible circuit board is tested.

9. Method according to any of claims 1 to 8 **characterised in that** there is used as contacting sensor a photoelectric beam (16) with an optical measuring section, in which a tab (17) connected to a test needle (2) engages to interrupt the optical measuring section.

10. Method according to any of claims 1 to 9 **characterised in that** a test probe (1) is used which has a test needle (2), the probe tip (5) of which may be brought into contact with the circuit board test points (22), and which is fastened pivotally to a mount (10) by means of two pairs of elastically sprung retaining arms (6, 7, 8, 9), wherein each pair of retaining arms is arranged in one plane, with one end fastened to the test needle (2) and the other end to the mount (10), with each pair of retaining arms forming a triangle when viewed from above.

11. Testing apparatus with a control unit for implementing the method according to any of claims 1 to 10.

**Revendications**

1. Procédé pour tester des cartes à circuits imprimés non garnies au moyen d'un dispositif de test à doigts qui comprend plusieurs doigts de contrôle, lesquels sont automatiquement déplacés pour venir en contact avec des points de test d'une carte à circuits imprimés qu'il s'agit de tester, dans lequel les doigts de contrôle comprennent chacun une sonde de contrôle (1) qui est dotée d'un capteur de venue en contact (16) au moyen duquel on détermine quand une pointe de contrôle (5) de la sonde de contrôle (1) entre en contact avec la surface de la carte à circuits imprimés qu'il s'agit de tester,
**caractérisé en ce que**, à l'aide de cet instant et de la position de la pointe de contrôle (5) à cet instant, on détermine le niveau de la surface de la carte à circuits imprimés (21) qu'il s'agit de tester, et les opérations de mise en contact pour établir le contact d'autres points de test sur la carte à circuits imprimés sont pilotées en fonction du niveau déterminé.

2. Procédé selon la revendication 1,
**caractérisé en ce que** lors de la venue en contact d'un point de test de la carte à circuits imprimés, les sondes de contrôle (1) sont déplacées à haute vitesse en direction du point de test (21 A) de la carte à circuits imprimés et sont freinées à une vitesse plus faible lorsqu'elles atteignent le niveau auparavant détecté ou brièvement avant.

3. Procédé selon la revendication 2,
**caractérisé en ce que** le mouvement de la sonde de contrôle (1) est arrêté lors de la venue en contact d'un point de test sur la carte à circuit imprimé dès qu'un contact avec la carte à circuit imprimé est constaté par le capteur de venue en contact (16).

4. Procédé selon l'une des revendications 1 à 3,
**caractérisé en ce que** l'on détermine au moyen du capteur de venue en contact (16) une force de contact déterminée avec laquelle la sonde de contrôle (1) est pressée contre une carte à circuits imprimés (21) qu'il s'agit de tester, et si l'on constate un écart de la force de contact détectée par rapport à une force de contact prédéterminée, la sonde de contrôle (1) est réajustée en correspondance.

5. Procédé selon l'une des revendications 1 à 4,
**caractérisé en ce que** l'on détecte les niveaux de plusieurs points agencés de manière répartie sur la carte à circuits imprimés, et **en ce que** l'on simule par un processus d'interpolation la surface de la carte à circuits imprimés à l'aide des niveaux détectés, ladite surface de stimuler étant utilisée pour piloter d'autres processus de mise en contact.

6. Procédé selon la revendication 5,

**caractérisé en ce que** le processus d'interpolation est le processus d'interpolation dit "Spline s".

7. Procédé selon l'une des revendications 1 à 6, **caractérisé en ce que**, au moyen de la surface simulée, on calcule des modifications des coordonnées X et des coordonnées Y des points de test sur la carte à circuits imprimés qui s'agit de tester par rapport à leurs coordonnées de consigne, et **en ce que** l'on pilote l'approche des points de test sur la carte à circuits imprimés en fonction de ces coordonnées X et de ces coordonnées Y modifiées.

8. Procédé selon l'une des revendications 1 à 7, **caractérisé en ce que** l'on teste une carte à circuits imprimés souple.

9. Procédé selon l'une des revendications 1 à 8, **caractérisé en ce que** l'on utilise comme capteur de venue en contact une barrière lumineuse (16) avec un trajet de mesure lumineux dans lequel s'engage une patte (17) reliée à une aiguille de contrôle (2) pour interrompre le trajet de mesure lumineux.

10. Procédé selon l'une des revendications 1 à 9, **caractérisé en ce qu'**on utilise une sonde de contrôle (1) qui comprend une aiguille de contrôle (2) dont la pointe de contrôle (5) peut être amenée en contact avec les points de test (22) sur la carte à circuits imprimés et qui est fixée en pivotement sur une monture (10) au moyen de deux paires de bras de maintien (6, 7, 8, 9) à effet ressort, dans lesquels les bras de maintien respectifs d'une paire sont agencés dans un plan, sont fixés par une extrémité sur l'aiguille de contrôle (2) et par l'autre extrémité sur la monture (10), et chaque paire de bras de maintien définit, vue en élévation, un triangle.

11. Dispositif de contrôle comprenant un système de commande pour mettre en oeuvre le procédé selon l'une des revendications 1 à 10.

FIG.1

FIG.2

FIG.3

FIG.4

EP 1 623 242 B1

FIG.5

15

**FIG.6**

EP 1 623 242 B1

FIG.7

17

FIG.8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0468153 A1
- EP 0853242 A1
- JP 2130477 A

- US 4926345 A
- US 5489855 A
- DE 10160119035